# EUROPEAN PATENT SPECIFICATION

(11) **EP 3 494 184 B1**
(45) Date of publication and mention of the grant of the patent: **27.01.2021**
(21) Application number: 17755259.3
(22) Date of filing: 03.08.2017
(51) Int. Cl.: C09D 11/037, C09D 5/24, C09D 11/322, C09D 11/52

(54) **FORMULATIONS AND PROCESSES FOR PRODUCING HIGHLY CONDUCTIVE COPPER PATTERNS**
FORMULIERUNGEN UND VERFAHREN ZUR HERSTELLUNG VON HOCHLEITENDEN KUPFERSTRUKTUREN
FORMULATIONS ET PROCÉDÉS DE PRODUCTION DE MOTIFS DE CUIVRE HAUTEMENT CONDUCTEURS

(30) Priority: 04.08.2016 IL 24711316
(43) Date of publication of application: 12.06.2019
(73) Proprietor: Copprint Technologies Ltd, 9330317 Jerusalem (IL)
(72) Inventor: GROUCHKO, Michael, 93303 Jerusalem (IL)
(74) Representative: Fleuchaus, Andrea
(86) International application number: PCT/IL2017/050860
(87) International publication number: WO 2018/025271

(56) References cited:
- EP-A1- 1 876 604
- EP-A1- 2 234 119
- WO-A1-2009/098985
- WO-A1-2015/152625
- US-A1- 2011 198 113

## Description

### TECHNOLOGICAL FIELD

This disclosure concerns formulations and processes for obtaining conductive patterns of copper onto a substrate.

### BACKGROUND ART

References considered to be relevant as background to the presently disclosed subject matter are listed below:
[1] Lee et al., J. Mater.Chem. 2012, 22, 12517-12522
[2] Farraj et al., Chem. Commun. 2015, 51, 1587-1590
[3] Park et al., Thin Solid Films 2007, 515, 7706-7711
[4] Jeong et al., J. Matter. Chem. C 2013, 1, 2704-2710
[5] Magdassi et al., ACS Nano 2010, 4, 1943-1948
[6] Grouchko et al., ACS Nano 2011, 5, 3354-3359
[7] Fitzsimons et al., J. Chem. Soc. Faraday Trans. 1995, 91(4), 713-718
[8] Soroka et al., Cryst. Eng. Commun. 2013, 15, 8450
[9] PCT patent publication WO 2012/077548
[10] PCT patent publication WO 2009/098985
[11] US patent publication US 8,801,971
[12] Venkata Abhinav et al., RCS Advances 2015, 5, 63985-64030
[13] Copper and Copper Alloys, Joseph R. Davis, ASM International 2001, pp. 181, 297

Acknowledgement of the above references herein is not to be inferred as meaning that these are in any way relevant to the patentability of the presently disclosed subject matter.

### BACKGROUND

Electrically conductive patterns may be obtained by printing conductive inks onto surfaces in various printing methods. Amongst the common conductive inks used are ink formulations based on silver particles; although providing sufficiently high conductivity, such inks are still relatively expensive, and thus problematic for utilization as part of large-scale production. Due to its high conductivity and relatively low cost, copper has been studied extensively as a potential material for obtaining highly conductive printed patterns. One of the methods for obtaining a conductive pattern involves printing a metallic, e.g. copper nanoparticles or a copper precursor, onto a substrate, followed by sintering or thermal decomposition of the nanoparticles or precursor in order to obtain a continuous metallic pattern **[1-4].** As known in the art, sintering is a process in which distinct particles of matter are heated to cause solid-state diffusion-driven bonding of the particles into a solid or substantially continuous mass (i.e. without melting and/or liquefying the particles during the process).

This sintering/decomposition step is typically carried out by heating the printed precursor to high temperatures (>150°C), typically for 10-60 minutes; however, due to its high oxidation rate, printing and post-printing sintering are also required to be carrying out under non-oxidative atmosphere (inert or reducing atmosphere). Such requirement often complicates the printing process, requires special printing equipment, and as a consequence increases the cost of production.

The use of a chemical sintering agent has been suggested for sintering precursors based on silver nanoparticles **[5-6].** However, due to its spontaneous oxidation and the presence of native copper oxide layer on the surface of copper nanoparticles, no solution exists to date for obtaining sintered copper patterns by chemical sintering approaches. As the presence of copper oxides functions as an effective barrier that hinders metal-metal interactions during the sintering process, sintering of copper nanoparticles typically involves heating to relatively high temperature for a prolonged period of time, optionally in the presence of reducing agents, in order to reduce the oxide and permit metal-metal interactions between the particles.

Another method for obtaining conductive copper patterns involves sintering at high temperatures (*ca.* 500-1000°C), typically by laser or photonics sintering. However, sintering at such temperatures often requires expensive printing/sintering equipment, which have a significant impact on the costs of production.

### GENERAL DESCRIPTION

The present disclosure provides an ink composition, which is based on copper nanoparticles, that permits printing and sintering under relatively low temperatures and air atmosphere. The unique ink formulation prevents formation of copper oxide during storage and subsequent printing and sintering, thereby resulting in a relatively fast process and highly conductive sintered patterns. As will become apparent from the disclosure, the ink formulations and the methods of obtaining conducting patterns therefrom allows for significantly reducing both the sintering temperature and duration, thereby reducing the complexity of the machinery required for the production process as well as the associated costs.

Thus, in one of its aspects, the present disclosure provides an ink formulation comprising copper nanoparticles, at least one copper-oxidizing agent, and copper hydride (CuH).

The term ***ink formulation*** means to denote copper-based compositions of matter that are suitable for applying, by various methods, onto a substrate for obtaining a pattern onto said substrate. In the ink formulation of this disclosure, an equilibrium between copper and copper hydride is obtained by the present of the at least one *copper-oxidizing agent,* namely by the presence of an agent that is capable of oxidizing copper. When added to a dispersion of copper nanoparticles, the copper-oxidizing agent oxidizes at least a portion of the copper (Cu⁰) into a cuprous ion (Cu⁺¹), thereby forming CuH in the formulation.

Although CuH may be formed as nanoparticles or flakes comprising substantially pure CuH, most of the CuH is formed onto the copper (Cu⁰) nanoparticles, namely as a continuous coating layer of CuH or as CuH domains (i.e. non-continuous coating) onto at least a portion of the copper nanoparticles. Regardless of their morphology, the CuH, in some embodiments, constitutes at least 0.1 wt%, at least 0.01 wt%, at least 0.001 wt%, or even at least 0.0001 wt% of the ink formulation.

Without wishing to be bound by theory, the CuH may function as a protecting layer against oxidation of copper into copper oxide. Further, once applied onto a substrate and heated, the CuH decomposes, thereby providing an H₂ atmosphere, preventing formation of copper oxide and affording sintering of the copper nanoparticles by metal-metal interactions.

In some embodiments, the CuH may be crystalline or amorphous. In some other embodiments, the CuH may be amorphous (e.g. characterized by showing no distinct peaks in an XRD analysis).

The term ***copper nanoparticles*** refers to discrete particles of copper (Cu⁰), at least one of their dimensions being in the nanometric range, typically 2 nm to 500 nm in length or diameter. The nanoparticles may be isotropic or anisotropic shaped nanoparticles. The nanoparticles may be selected to display any branched and net structures. Without being limited thereto, the nanoparticles may be symmetrical or unsymmetrical, may be elongated having a rod-like shape, round (spherical), elliptical, pyramidal, disk-like, branch, network or any irregular shape. In some embodiments, the nanoparticles are selected from quantum dots (QD), nanocrystals, nanospheres, nanorods, nanowires, nanocubes, nanodiscs, branched nanoparticles, multipods and others. The nanoparticles may be of a single type of nanoparticles or of a mixture of nanoparticle types.

In some embodiments, the nanoparticles are substantially spherical. As used herein, the term *spherical,* or any lingual variation thereof, refers generally to a substantially (nearly) round-ball geometry.

In some embodiments, at least a portion of the nanoparticles have a disk-like shape. By such embodiments, between about 10 and 90 % of the nanoparticles may be disk-shaped, which may have a diameter of between about 20 and 200 nm and/or thickness of 5 to 50 nm.

In other embodiments, the nanoparticles have an averaged diameter of at most 600 nm. In some other embodiments, the nanoparticles have an averaged diameter of between about 10 and 100 nm.

The term ***averaged diameter*** refers to the arithmetic mean of measured diameters, wherein the diameters range ±25% of the mean. Where the nanoparticles are non-spherical, the term refers to an arithmetic mean of the equivalent spherical diameter of the nanoparticles.

In some embodiments, the formulation may comprise between about 10 and 90 wt% of copper nanoparticles. In other embodiments, the formulation may comprise between about 20 and 80 wt% copper nanoparticles.

Although primarily containing copper nanoparticles, the ink formulations may further comprise at most 90 wt% of copper microparticles. Such microparticles may be added, for example, when seeking at providing bi-modal size distribution of copper particles in the dispersion which may have an impact on processes utilizing the ink formulation. One non-limiting example may be the sintering of a printed pattern of the ink formulation to obtain a sintered copper pattern, in which the grain size copper may have an effect onto the resultant electric conductivity (or resistance) of the sintered pattern.

At times, the ink formation may comprise mostly microparticles. Thus, in another aspect there is provided an ink formulation comprising copper microparticles, at least one copper-oxidizing agent, and copper hydride (CuH).

The term ***microparticles*** refers to copper particles typically having an averaged size of between about 600 nanometer and 100 micrometers.

The formation of CuH in the ink formulation is afforded by the copper-oxidizing agent. Once CuH and the copper particles (Cu⁰) (nanoparticles and/or microparticles) reach an equilibrium state, the presence of the copper-oxidizing agent maintain the balance between these two components in the ink formulation until exposed to conditions that cause sudden decomposition of the CuH (such as in a heating process, as described further below).

The term ***copper-oxidizing agent*** means to denote any agent that is capable of oxidizing copper; i.e. transforming Cu⁰ into Cu⁺¹, resulting in CuH formation.

In some embodiments, the copper-oxidizing agent may be selected from organic acids, inorganic acids and anhydrides, alcohols, aldehydes, and hydroxyamines.

The term ***inorganic acid*** is meant to denote a compound that does not contain carbon atoms and is capable of donating protons in an ionic bond with an anion. The inorganic acid may be a liquid or a solid that is soluble in the ink formulation (i.e. in a suitable liquid carrier). Suitable inorganic acids according to the present disclosure are those capable of oxidizing copper, namely transforming Cu⁰ into Cu⁺¹.

In some embodiments, the copper-oxidizing agent is a phosphorous-containing compound, namely an inorganic acid or anhydride containing phosphorous atoms. The phosphorous-containing compound may be selected from hypophosphorous acid, phosphorous acid, phosphoric acid, pyrophosphoric acid (H₄P₂O₇), tripolyphosphoric acid (H₅P₃O₁₀), tetrapolyphosphoric acid (H₆P₄O₁₃), trimetaphosphoric acid (H₃P₃O₉), phosphoric anhydride (P₄O₁₀), polyphosphoric acid, hypophosphoric acid (H₄P₂O₆), pyrophosphorous acid (H₄P₂O₅), and metaphosphorous acid (HPO₂), and mixtures thereof.

In other embodiments, the phosphorous-containing compound is hypophosphorous acid (HPA, also known as phosphinic acid), having the chemical formula HOP(O)H₂.

According to some embodiments, the ink formulation comprises between about 0.001 and 20 wt% of said copper-oxidizing agent. According to other embodiments, the formulation may comprise between about 0.01 and 5 wt% of the copper-oxidizing agent.

In order to maintain equilibrium between Cu⁰ and CuH, the ratio between the copper-oxidizing agent and the copper nanoparticles may, by some embodiments, be between about 0.001 and about 0.2 (wt/wt) (i.e. the copper-oxidizing agent may be present in the formulation in a weight amount of between 0.1% and 20% compared to the weight amount of the copper nanoparticles).

The formulations of this disclosure are typically provided as a dispersion, either in liquid form or as a paste. Thus, in some embodiments, the ink formulation may further comprise at least one ***liquid carrier.*** The viscosity of the ink formulation may be tailored to a specific application method by use of a suitable liquid carrier and its relative amount in the formulation. The liquid carrier may be any liquid that on the one hand solubilizes the copper-oxidizing agent and on the other permits dispersion of the copper nanoparticles therein.

As the ink formulation may undergo various thermal processes (as will be described further below), it is often desired that the liquid carrier be selected to have a boiling point that permits its evaporation upon exposure to said thermal process. In some embodiments, the liquid carrier may be selected as to have an evaporation rate and/or boiling point that is different from the copper-oxidizing agent, e.g. the carrier liquid may have a higher boiling temperature and/or a lower evaporation rate compared to the copper-oxidizing agent. In other embodiments, where the presence of the copper-oxidizing agent is desired in the dried pattern, the carrier liquid may be selected to have a lower boiling temperature and/or a higher evaporation rate compared to the copper-oxidizing agent.

In some embodiments, the liquid carrier may be selected from water, glycol ethers, glycol ether acetates, alcohols and mixtures thereof.

In other embodiments, the liquid carrier may be selected from terpineol, ethylene glycol monomethyl ether, ethylene glycol monoethyl ether, ethylene glycol monopropyl ether, ethylene glycol monoisopropyl ether, ethylene glycol monobutyl ether, ethylene glycol monophenyl ether, ethylene glycol monobenzyl ether, ethylene glycol monohexyl ether, diethylene glycol monomethyl ether, diethylene glycol monoethyl ether, diethylene glycol mono-n-butyl ether, diethylene glycol monohexyl ether, ethylene glycol monomethyl ether acetate, ethylene glycol monoethyl ether acetate, ethylene glycol monopropyl ether acetate, ethylene glycol monoisopropyl ether acetate, ethylene glycol monobutyl ether acetate, ethylene glycol monophenyl ether acetate, ethylene glycol monobenzyl ether acetate, ethylene glycol monohexyl ether acetate, diethylene glycol monomethyl ether acetate, diethylene glycol monoethyl ether acetate, diethylene glycol mono-n-butyl ether acetate, diethylene glycol monohexyl ether acetate, diethylene glycol n-butyl ether acetate, propylene glycol, dipropylene glycol methyl ether, tripropylene glycol methyl ether, and mixtures thereof.

In some other embodiments, the liquid carrier is water or an aqueous-based liquid carrier. Without wishing to be bound by theory, water is considered to have a relatively low boiling point compared to glycol ethers or glycol ether acetates. Thus, when low-temperature sintering is desired, e.g. at a sintering temperature of 200°C and lower, water may be used as a liquid carrier instead of glycol ethers or derivatives thereof.

According to some embodiments, the ink formulation may comprise at most 90 wt% of said liquid carrier. According to other embodiments, the liquid carrier may be present in the formulation in an amount of between about 10 and 90 wt%.

The formulations of this disclosure may also be provided as solvent-free formulations, i.e. substantially devoid of a liquid carrier. Such formulations may be in the form of a pliable paste. In some embodiments, the ink formulation further comprises a polymeric matrix material, in which the copper particles, copper-oxidizing agent and CuH are dispersed. The polymeric matrix material may be thermoplastic or thermosetic, typically in resinous form, and may be selected from one or more monomers, one or more oligomers or one or more polymers. In some embodiments, the polymeric matrix material may be selected from epoxy resins and any derivative thereof.

The ink formulation of this disclosure may comprise a variety of other components having various functionalities.

In some embodiments, the ink formulation may further comprise at least one stabilizer. The ***stabilizer*** may be adsorbed or otherwise physically associated with the surface of the copper nanoparticles, such that repulsion forces (i.e. by electrical charges, dipoles, or charge distribution) and/or steric hindrance distance the copper nanoparticles from one another, thereby permitting their dispersion in the liquid carrier and substantially preventing their aggregation.

According to some embodiments, the formulation may comprise between about 0.1 and 30 wt% of said stabilizer.

Ink formulations of this disclosure, as noted above, may further comprise various additives which, by some embodiments, may be selected from a binder, a wetting agent, a humectant, a co-solvent, pH adjusting agent, leveling agent, and others.

In another aspect, this disclosure provides a kit for preparing an ink formulation as described herein. The kit comprises a first container comprising a dispersion or a paste or a powder of copper nanoparticles in a liquid carrier; and a second container comprising a solution, a paste or a powder of at least one copper-oxidizing agent capable of oxidizing copper for forming CuH (e.g. an inorganic acid).

In some embodiments, each of the containers comprised in the kit are made available separately. Each of the first and second containers may be a generic container as known to any person of skill in the art. In some embodiments, each of the containers is adapted to fit into a print-head of a suitable patterning printer, such as an ink-jet printer.

In other embodiments, the kit further comprises a housing for holding the first and second containers. In such embodiments, the housing may be a cartridge, housing at least 2 compartments for receiving said containers. In other such embodiments, each of the first and second container may be constituted by a first and a second compartment, respectively, of a cartridge.

In other embodiments, the first and second containers may be integral one with the other and linked by means for selectively mixing their contents; namely, the first and second containers are linked, for example by a removable seal or a valve, such that once the seal is removed, the contents of the containers may be mixed one with the other upon demand (for example by shaking or by spontaneous diffusion-based mixing).

In another aspect, the disclosure provides a printed pattern comprising the ink formulation as described herein. As a person of the art may appreciate, the pattern may be printed by the formulation *per-se*, i.e. by a single formulation *a priori* containing all of the formulation's components. Alternatively, the formulation may be formed onto the substrate, for example by first applying at least some of the components onto the substrate, and subsequently applying the remainder of components thereonto.

The term ***pattern*** refers to any shape, of any size, formed onto the substrate by the formulation. For example, the pattern may be a single geometrical or abstract shape. Alternatively, the pattern may comprise a plurality of such shapes, being of identical or different size, distributed in a random or ordered manner on the substrate. The term also encompasses lines, letters, numerals, symbols, electrical circuits, etc.

In another aspect, there is provided a sintered printed pattern comprising copper and copper-oxidizing agent as defined herein.

In some embodiments, the sintered printed pattern comprises between about 0.001 and 1 wt% of said copper-oxidizing agent.

In yet another aspect, the disclosure provides a sintered printed pattern comprising copper up to 0.1 mol% phosphorous, e.g. between about 0.00000001 and 0.1 mol% of phosphorous. It is to be understood that phosphorous can be present in the sintered printed pattern as part of residues of a phosphorous-containing copper-oxidizing agent, as elemental phosphorous and/or as part of phosphorus-copper alloys. In some embodiments, the sintered printed pattern may comprise between about 0.00000001 and 0.01 mol% of phosphorous, between about 0.00000001 and 0.001 mol% of phosphorous, or even between about 0.00000001 and 0.0001 mol% of phosphorous.

Without wishing to be bound by theory, the formation of copper-phosphorous alloys may assist in lowering the sintering temperature of the pattern. Phosphorous-copper alloys were suggested to be more stable to oxidation **[13],** and are typically characterized by a low melting point (compared to pure copper). Thus, the presence of phosphorus within the lattice may assist in reducing the overall sintering temperature of the ink formulation.

As noted above, the formulations may be printed directly onto the substrate (i.e. as a single ink formulation). In the alternative, the formulation may be formed onto the substrate by a multiple-steps, typically 2-steps, process, in each step at least some of the formulation's components are applied to the substrate.

Thus, by another aspect, this disclosure provides a process for obtaining a pattern onto a substrate, the process comprising applying an ink formulation of this disclosure onto at least a surface region of said substrate. This aspect will be referred to as ***the single-step application process.***

In some embodiment, the ink formulation may be applied onto the substrate by any suitable application method, for example by ink-jet printing, screen printing, spin coating, roll coating, spray coating, dip coating, flow coating, doctor blade coating, dispensing, offset printing, pad printing, gravure printing, flexography, stencil printing, imprinting, xerography, lithography, stamping, or any other suitable application method.

In another aspect, the disclosure provides a process for obtaining a pattern onto a substrate, the process comprising:
(a) applying a dispersion or a paste that comprises copper nanoparticles in a liquid carrier onto at least a surface region of the substrate;
(b) applying at least one copper-oxidizing agent;
(c) permitting at least a portion of the copper nanoparticles to react with said copper-oxidizing agent for transforming Cu⁰ into CuH, thereby obtaining a pattern of an ink formulation onto the substrate.

This aspect will be referred to as ***the multiple-step application process.***

As a man of the art would appreciate, the sequence of steps (a) and (b) in the multiple-step process may be interchanged. Thus, in some embodiments, the dispersion or paste is applied onto the substrate, followed by application of the copper-oxidizing agent. In other embodiments, application of the copper-oxidizing agent is carried out first, followed by application of the dispersion or paste.

In some embodiments, the application of the dispersion or paste onto the substrate may be carried out by ink-jet printing, screen printing, spin coating, roll coating, spray coating, dip coating, flow coating, doctor blade coating, dispensing, offset printing, pad printing, gravure printing, flexography, stencil printing, imprinting, xerography, lithography, stamping, or any other suitable application method.

In other embodiments, the application of the copper-oxidizing agent may be carried out by printing, pasting, dipping, fumigating, or spraying.

The multi-steps process may further comprise a step (c'), carried out after step (c), of washing the substrate.

Both the single-step process and the multi-step process may optionally comprise a step of drying the pattern after its application (and where applicable after a wash step) onto the substrate. Drying may be carried out, for example, at a temperature of between about 20 and 200°C, and/or for a period of time of between 1 and 600 seconds, and/or in an air atmosphere.

The pattern may be formed on any suitable ***substrate*,** which may be a flexible or rigid substrate, stretchable or pliable, absorbing or non-absorbing, conductive or nonconductive, colored or transparent, which may be substantially two-dimensional (a thin flat substrate), a three-dimensional curved (non-flat) surface, an un-even or non-homogenous surface, etc. The surface can be of any smoothness. In most general terms, the substrate may be of a solid material such as metal, glass, paper, a semiconductor, a polymeric material, a ceramic surface, or even a hybrid substrate containing several different materials. The surface material, being the substrate on which the ink formulation is applied, may not necessarily be of the same material as the bulk of the substrate. For example, the substrate may comprise an outer layer, which is different from the bulk material, onto which the ink formulation of this disclosure is applied. A non-limiting example of such substrates may be painted substrates or glazed substrates. In some embodiments, the surface is substantially two-dimensional. In other embodiments, the surface is that of a three-dimensional object or article.

The substrate may have a uniform surface, i.e. of substantially uniform surface roughness, made of a single material (or a single composition), and/or have a uniform thickness. However, it is of note that in the context of the present disclosure, the surface may be non-uniform. Namely, the surface of the substrate may include at least 2 sections, differing in at least one of roughness, height, thickness, material or composition, etc. The at least 2 sections may be integral one with the other or have gaps between them (i.e. the substrate sections may be *continuously-associated*). For example, one of the substrate sections may be a tube while the other substrate section can be a cap to be associated with the tube, such that a small gap is formed between the tube and the cap. Thus, methods of this disclosure may be applied as continuous printing onto multi-sectioned substrates.

The ***surface*** may be the whole surface or any region thereof. The ***regions*** may be of any size and structure; the regions may be continuous, integral one with the other, or comprised of several non-continuous spaced apart regions. In some embodiments, the regions are integral one with the other. The regions refers also to a plurality of regions, at least two regions in said plurality differing one from the other by said at least one property (i.e. composition, texture, thickness, etc.). Thus, the term means to encompass also a plurality of regions being different from a plurality of other regions by said property, all regions are formed onto the surface or a portion thereof.

It is to be understood that in the multiple-steps process, application of the copper-oxidizing agent may be on the entire surface of the substrate, onto the pattern regions, or onto portions of the pattern regions. Namely, the copper-oxidizing agent may be applied non-selectively onto the entire surface of the substrate, whereby the oxidation of Cu⁰ to CuH reaction will occur only in the patterned regions; or applied selectively onto the entire regions or any portion thereof.

As noted above, the patterns of this disclosure may undergo a thermal process to decompose CuH and cause sintering of the Cu nanoparticles one to the other for obtaining conductive patterns.

The term ***sintering*** refers to the formation of a continuous matrix of material, in this case copper, from discrete particulate material by a thermal process. Heating of the particulate material promotes diffusivity of metal atoms between adjacent, contacting, particles, thereby forming a continuous metallic matrix with reduced porosivity. By sintering, a non-conductive pattern made of copper nanoparticles is transformed into a continuous conductive copper matrix (or grid).

It is another aspect of the present disclosure to provide a process for obtaining a conductive copper pattern on a substrate, the process comprises printing an ink formulation of this disclosure onto at least a surface region of said substrate to obtain a pattern-bearing substrate; and exposing said pattern-bearing substrate to conditions permitting decomposition of CuH and sintering of copper, said exposing being for a period of time of between about 0.01 and 600 seconds, to thereby obtain a conductive copper pattern. This aspect will be referred to as ***the single-step sintering process*** (where *"single-step"* refers to a single of application of the ink formulation onto the substrate).

In such cases, the copper-oxidizing agent may be formulated into the ink formulation in advance or may be introduced into the copper solution/paste before printing the pattern. The mixing of the copper-oxidizing agent into the ink formulation may be carried out as a printing pre-stage, or may even be carried out within the printer (i.e. in the ink cartridge or within the printing nozzle).

In another aspect, there is provided a process for obtaining a conductive copper pattern onto a substrate, the process comprising:
(i) printing a dispersion or a paste that comprises copper nanoparticles in a liquid carrier onto at least a surface region of the substrate;
(ii) applying at least one copper-oxidizing agent to said substrate;
(iii) permitting at least a portion of the copper nanoparticles to react with said copper-oxidizing agent for transforming Cu⁰ into CuH, to thereby obtain a pattern-bearing substrate;
(iv) exposing said pattern-bearing substrate to conditions permitting decomposition of CuH and sintering of copper, said exposing being for a period of time of between about 0.01 and 600 seconds, to thereby obtain a conductive copper pattern.

This aspect will be referred to as ***the multiple-steps sintering process*** (where *"multiple-step"* refers to application of the ink formulation in several steps).

Similar to the above, the sequence of steps (i) and (ii) in the multiple-step sintering process may be interchangeable.

In some embodiments, step (i) may be carried out by ink-jet printing, screen printing, spin coating, roll coating, spray coating, dip coating, flow coating, doctor blade coating, dispensing, offset printing, pad printing, gravure printing, flexography, stencil printing, imprinting, xerography, lithography, stamping, or any other suitable application method.

In other embodiments, step (ii) may be carried out by printing, pasting, dipping, fumigating, or spraying.

According to some embodiments, the copper-oxidizing agent may be applied by dipping the substrate in a solution (based on the liquid carrier, i.e. aqueous-based or organic solvent-based) comprising at least 1 wt% of said copper-oxidizing agent. In such embodiments, the dipping may be carried out for between about 0.1 and 600 seconds.

According to other embodiments, the copper-oxidizing agent may be applied by exposing the substrate to fumes of the copper-oxidizing agent for between about 1 second and 3 hours.

Regardless of the method by which step (ii) is carried out, the multi-steps sintering process may further comprise a step (iii'), carried out after step (iii), of washing the substrate.

Both the single-step and the multi-steps sintering process may optionally comprise a step of drying the pattern-bearing substrate (where applicable after a wash step) prior to sintering. Drying may be carried out, for example, at a temperature of between about 20 and 200°C, and/or for a period of time of between 1 and 600 seconds, and/or in an air atmosphere.

In some embodiments, the conditions permitting decomposition of CuH and sintering of copper may comprise exposing the pattern-bearing substrate to a temperature of at least 125°C. In other embodiments, the substrate may be exposed to a temperature of between about 125°C and 500°C. It is of note that sintering at temperatures higher than 500°C or lower than 125°C (e.g. between about 50 and 125°C) is also contemplated.

In some other embodiments, the pattern-bearing substrate is exposed to elevated temperatures (i.e. at least 125°C) for a period of time of between about 0.01 and 600 seconds. Without wishing to be bound by theory, the higher the sintering temperature the shorter the exposure period of the pattern-bearing substrate to such temperature. As a person versed in the art appreciate, the pattern may be exposed to a single (i.e. uniform) temperature throughout the sintering temperature or to a variable temperature profile; for example, the sintering process may include two or more steps carried out at different temperatures for different exposure periods. The change in temperature may be gradual (i.e. the temperature may be increased or decreased in various rates) or a sudden change (sudden increase or decrease of temperature).

According to some embodiments, the decomposition of CuH and sintering of copper is carried out in air atmosphere.

According to other embodiments, the decomposition of CuH and sintering of copper is carried out in a local reducing atmosphere, namely in an atmosphere of gaseous reducing species. The reducing atmosphere may be obtained in-situ by the formation of gaseous reducing agents due to the decomposition of CuH and the copper oxidizing agent (for example, the formation or hydrogen as a decomposition product). Alternatively, the reducing atmosphere may be obtained by introduction of gaseous reducing species during sintering.

It is of note that CuH decomposition and sintering may be carried out immediately after application of the formulation, or at any time thereafter. Sintering may be carried out as a distinct step, or as part of a continuous production line (i.e. as station following a printing station in a single production line). It may be carried out inside a printer, i.e. an inkjet printer may be equipped with an *in-situ* sintering system that enables the sintering of the printed pattern, or as a separate unit. The sintering process may include the heating of the pattern-bearing surface by any suitable means, such as a heating lamp (Xenon, NIR and the like) lamp flashes, UV lamp, laser, hot air, oven or any other thermal process unit.

In another embodiment, the sintering may be selective. Selective sintering refers to sintering of a selected portion or portions of the pattern, resulting in desired sections of the pattern which are sintered and others which are not sintered. Such selective sintering may be obtained, for example, by exposing the printed pattern to a radiation source (e.g. infra-red or near infra-red radiation) via a suitable blocking mask. The mask may be detachably placed on the printed pattern prior to exposure to the radiation source or may be disposed between the radiation source and the patterned surface. Selective sintering may also be obtained by other suitable means, such as laser scanning.

As noted above, during the sintering process, the printed pattern is being heated to an elevated temperature for a predetermined period of time, during which one or more processes occur; i.e. elevated temperatures may cause the CuH to decompose, the reactivity of the copper-oxidizing agent with the copper may increase (thus leading to the formation of additional CuH) and/or the copper-oxidizing agent may decompose. These processes are highly exothermic, causing extreme and rapid increase of the local temperature in the printed pattern. Thus, when printed onto a sensitive substrate (such as paper), scorch marks may be observed at times on the substrate, attesting to the sintering process carried out on ink formulations of this disclosure.

Further, due to the exothermic effect and local heating as a result of the chemical reaction, it is contemplated that sintering may be carried out at low temperatures, i.e. at the lower sintering temperature range described herein.

Another aspect of the present disclosure provides a conductive copper pattern having % bulk conductivity of at least 5%. In some embodiments, the pattern is obtained by the processes described herein.

The term percent (%) ***bulk conductivity*** refers to the electrical conductivity of the sintered pattern relative to the electrical weight conductivity of bulk copper measured in the same conditions.

A further aspect provides a conductive copper pattern substantially free of copper oxide, the pattern obtained by the processes described herein.

The conductive copper patterns may be manufactured on a surface of a 2D or 3D object, or to be embedded within a 3D object. For example, in the case of a thermoplastic/thermosetic inkjet printing, the ink formulation may be one of the printed inkjet inks and in a layer by layer method. This would provide a plastic object with metal parts embedded inside. In the case of powder-bed inkjet printing, the copper ink formulation may be printed on top of the powder, while the powder serves as the filler and the copper particles as the conductive material. Furthermore, the object may be constituted by ink formulation, namely, ink formulations of this disclosure may be used to produce 3D metallic objects, whether or not sintered.

In another aspect, the disclosure provides an article comprising a conductive copper pattern as described herein. Exemplary articles comprising the conductive copper patterns may be solar cells, EMI shielding, RFID tags, electroluminescent devices, OLEDs, LCDs, touch screens, antennas, heaters, defoggers, PCBs or any other device which requires electrodes.

As used herein, the term ***"about"*** is meant to encompass deviation of ±10% from the specifically mentioned value of a parameter, such as temperature, concentration, etc.

Whenever a numerical range is indicated herein, it is meant to include any cited numeral (fractional or integral) within the indicated range. The phrases **"*ranging*/*ranges between*"** a first indicate number and a second indicate number and "ranging/ranges from" a first indicate number "to" a second indicate number are used herein interchangeably and are meant to include the first and second indicated numbers and all the fractional and integral numerals therebetween.

### BRIEF DESCRIPTION OF THE DRAWINGS

In order to better understand the subject matter that is disclosed herein and to exemplify how it may be carried out in practice, embodiments will now be described, by way of non-limiting example only, with reference to the accompanying drawings, in which:
**Fig. 1** shows the % bulk conductivity of sintered copper patterns obtained at different sintering temperatures after a 2-steps printing process in which HPA was applied by dipping.
**Fig. 2** shows sintering for various periods of time, at a constant temperature of 150°C in air after a 2-steps printing process in which HPA was applied by dipping.
**Figs. 3A-3D** show SEM images of non-sintered printed pattern and patterns sintered at 150, 200 and 225°C, respectively.
**Fig. 4** shows the results of an XRD analysis of a pattern sintered at 200 °C.
**Fig. 5** shows sheet resistance as a function of HPA/Cu weight ratio for sintered patterns prepared from 60 wt% Cu paste.
**Fig. 6** shows an E52 antenna printed on paper using formulations of this disclosure.
**Fig. 7** shows the results of an EDX analysis of a pattern sintered at 150 °C, with Cu and P peaks.

### DETAILED DESCRIPTION OF EMBODIMENTS

In the following examples, Cu nanoparticles (NPs) were used. Methods for preparing such nanoparticles are known, for example from **[12].**

### Example 1: Single-step printing

### Single-step printing ink formulations

A copper NPs dispersion was washed in an ultrafiltration membrane (CO=100KDa, PES). In some formulations, the water was exchanged with various liquid carriers to obtain formulations having 30-60 wt% copper in the liquid carrier. The obtained red color ink was easily filtered through a 1µm syringe filter. Hypophosphorous acid (HPA) was added to the mixtures for obtaining formulations suitable for single-step printing, as detailed in **Table 1.**

In all of the formulations below the addition of HPA induced formation of CuH.

**Table 1: formulations for single-step printing**

| **Formula #** | **Cu (wt%)** | **Acid (wt%)** | **Carrier** | **Binder** | **Form** |
|---|---|---|---|---|---|
| 1 | NPs (30%) | HPA (0.1%) | water | - | Liquid dispersion |
| 2 | NPs (30%) | HPA (0.1%) | dipropylene glycol methyl ether | lwt% polyvinyl pyrrolidone (MW =40,000) | Liquid dispersion |
| 3 | NPs (30%) | HPA (0.6%) | dipropylene glycol methyl ether | lwt% polyvinyl butyral | Liquid dispersion |
| 4 | NPs (60%) | HPA (2%) | dipropylene glycol methyl ether | - | Paste |
| 5 | NPs (60%) | HPA (2%) | dipropylene glycol methyl ether | lwt% polyvinyl butyral | Paste |
| 6 | NPs | HPA | dipropylene | - | Paste |
| | (30%) | (2%) | glycol methyl ether | | |
| | 1-5 µm MPs (30%) | | | | |
| 7 | NPs (30%) | HPA (2%) | dipropylene glycol methyl ether | lwt% polyvinyl butyral | Paste |
| | 1-5 µm MPs (30%) | | | | |
| 8 | NPs (60%) | HPA (15%) | Terpineol | 2wt% ethyl cellulose | Paste |
| 9 | NPs (70%) | HPA (15%) | Water/glycerol mixture | 2wt% polyvinyl pyrrolidone (MW =36,000) | Paste |
| 10 | NPs (52%) | HPA (1.4%) | dipropylene glycol methyl ether | - | Paste |
| 11 | NPs (45%) | HPA (10%) | dipropylene glycol methyl ether | - | Paste |
| 12 | NPs (32%) MPs (26%) | HPA (8.7%) | dipropylene glycol methyl ether | - | Paste |
| 13 | NPs (64%) | HPA (1.6%) | dipropylene glycol methyl ether | | Paste |
| 14 | NPs (64%) | HPA (1.6%) | Diethylene Glycol n-Butyl Ether | | Paste |
| 15 | NPs (64%) | HPA (1.6%) | Terpineol | | Paste |
| 16 | NPs (64%) | HPA (0.7%) | dipropylene glycol methyl ether | | Paste |
| 17 | NPs (64%) | HPA (0.7%) | Diethylene Glycol n-Butyl Ether | | Paste |
| 18 | NPs (64%) | HPA (0.7%) | Terpineol | | Paste |
| 19 | NPs (64%) | HPA (2.5%) | Terpineol | | Paste |
| 20 | NPs (64%) | HPA (1.6%) | water | | Paste |
| 21 | NPs (64%) | HPA (2.5%) | water | | Paste |
| 22 | NPs (30%) | HPA (0.01%) | water | - | Inkjet ink |
| 23 | NPs (30%) | HPA (0.01%) | dipropylene glycol methyl ether | 1wt% polyvinyl pyrrolidone (MW =40,000) | Inkjet ink |
| 24 | NPs (30%) | HPA (0.06%) | dipropylene glycol methyl ether | 1wt% polyvinyl butyral | Inkjet ink |

### Single-step printing

A dipropylene glycol methyl ether based dispersion of Example 1.1 with 30 wt% copper was mixed with HPA at a weight ratio 0.08 (copper/HPA). That ink formulation was inkjet-printed using a DMC dimatix inkjet head. The printing was found to be stable. The obtained patterns were sintered at 300°C at air atmosphere and the resistance was measured. The calculation of the resistivity (according to the obtained line profile) led to 7 µΩ×cm, which is equal to 24% of the copper bulk conductivity. XRD analysis showed 100% fcc copper in the obtained patterns with no oxides.

### Example 2: Two-steps printing

In the two-steps printing, the substrate was first printed with a dispersion of copper nanoparticles obtained by the synthesis described in example 1.1 in the carrier liquid to obtain a pattern. The pattern was dried at a temperature of 20-150 °C for a period of a few seconds up to a few minutes.

Then a solution of HPA is applied onto the pattern, allowed to react with the copper NPs for forming CuH, thereby forming a pattern of the ink formulation onto the substrate. Subsequent to formation of CuH, the pattern is heated, resulting in a sintered conductive copper pattern.

Formulations similar to those detailed in Table 1, however without the inorganic acid, may be used as a dispersion for printing the copper NPs' pattern onto the substrate.

10-50 wt% solutions of the HPA were prepared by dissolving HPA in the liquid carrier, for example in dipropylene glycol methyl ether, and then applied onto the printed pattern to allow the oxidation of copper to CuH, and subsequently sintered.

### Application of HPA by printing

A solution of 10 wt% HPA in dipropylene glycol methyl ether was inkjet-printed onto a pre-printed copper NPs pattern. Then the pattern was heated to 140 °C for 10 seconds in air. Resistances of 0.05 to 1 Ω (Ohms) were measured along 1 cm line.

### Application of HPA by dipping

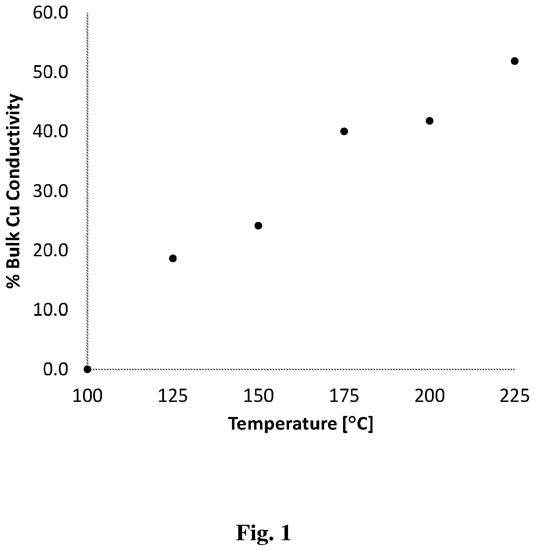

Copper NPs printed patterns were dipped for 1-10 sec in a 50 wt% HPA/water solution. Then the pattern was washed for up to 1 min in water and dried at 60-150 °C for 5-60 sec. Then, the pattern was sintered for 1 sec to 20 minutes in air at a temperature of 125-500°C. **Fig. 1** shows the change in electrical resistance as a function of sintering temperature for a liquid dispersion ink formulation printed on paper and then dipped in a 50 wt% HPA for 5 sec, washed for 30 sec in water and then sintered for 60 seconds in air. Without wishing to be bound by theory, at sintering temperatures higher than 120°C, CuH decomposes to form a local H2 atmosphere that prevents the formation of copper oxides and permits metal-metal interactions for sintering.

### Application of HPA by fumigation

Copper NPs printed patterns were placed in a container together with a 50 wt% HPA/water solution and heated to 20-130 °C. As the temperature increased, more HPA vapor was formed, resulting in a shorter required exposure time in order to obtain CuH. The exposure time was in the range of 10sec - 3hrs.

In an exemplary process, 30 wt% copper ink (as described in example 1.1) was used to print copper patterns on paper and Kapton® (polyethylene imide). The patterns were exposed to HPA vapor at (i) 130°C for 30 sec, or (ii) 50°C for 3 hrs. After the exposure, the patterns were sintered at 250°C for 2 sec. The obtained sheet resistance was less than 0.1 Ω/sq.

### Effect of sintering process parameters on conductivity

### Effect of sintering temperature

As noted above, **Fig. 1** shows the % bulk conductivity of sintered copper patterns obtained at different sintering temperatures; all samples were sintered for 60 seconds in air. As can be seen, values of at least 20% bulk-conductivity were obtained, and increased with increase in sintering temperature, seemingly due to the increased rate and extent of thermal decomposition of CuH.

### Effect of sintering duration

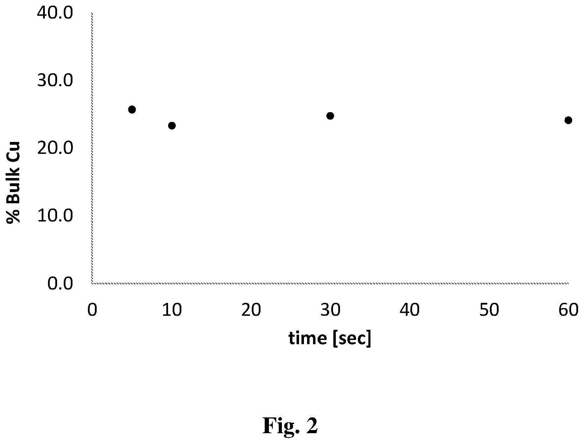

**Fig. 2** shows sintering for various periods of time, at a constant temperature of 150°C in air. As evident from Fig. 2, sintering occurs within a few seconds (as fast as 2 seconds of exposure to 150 °C), as no significant change in %-bulk conductivity was observed over time. This also attests to a mechanism of sintering that does not involve the formation and decomposition of copper oxides, as higher temperatures (above 150°C, typically about 250-300 °C) and significantly longer sintering duration (at least 1 hour) are required for decomposition copper oxide.

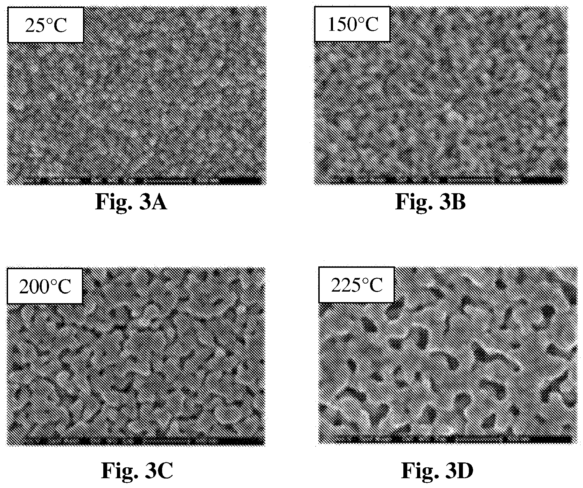

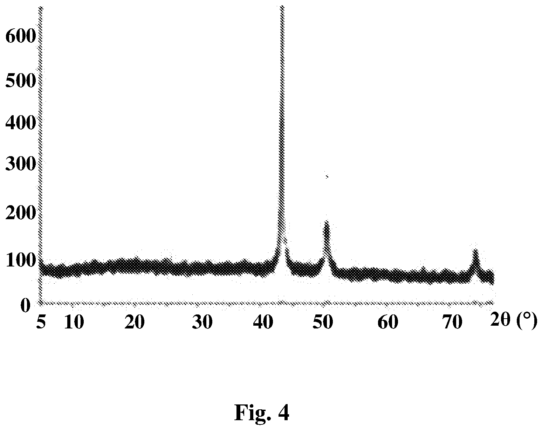

**Figs. 3A-3D** show, respectively, SEM images of non-sintered printed pattern and patterns sintered at 150, 200 and 225°C. These images show the formation of a continuous grid of copper particles, that results in a conductive sintered pattern. As evident from the XRD analysis shown in **Fig. 4****,** the sintered pattern contains 100% metallic copper, with no detected copper oxides.

### Effect of HPA/Cu ratio

The effect of the HPA/Cu weight ratio on the obtained resistivity of a 60 wt% Cu paste prepared according to example 1 was evaluated.

That paste was screen printed on Kapton® film and sintered at 300 °C for 2 sec.

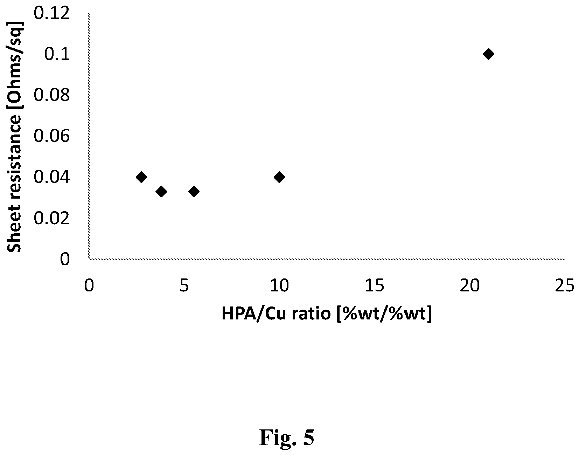

As seen in **Fig. 5****,** HPA/Cu weight ratio of 3-4% (i.e. HPA/Cu wt/wt=0.03-0.04) led to the lowest sheet resistance.

### Stability of sintered patterns

Durability test results at 85% humidity and 85 °C revealed that the sintered patterns are stable. Without any coating, the resistivity increased by 44% after 408 hrs, and 26% with a sealant layer. These results indicate that the sintered patterns obtained from the formulations and processes of this disclosure are very stable, and very high conductivities were maintained even after exposure to extreme conditions.

### NIR sintering

Near infra-red (NIR) sintering of formulations of this disclosure was also evaluated. Lamps of 800 W were used to sinter samples prepared according to examples 3 and 4 in Table 1. The samples were exposed to the NIR lamp for 0.5 to 5 sec and yielded sheet resistance down to 0.07 Ω/sq.

Such a sintering approach enables also selective sintering by exposing the sample to NIR lamp through a protection mask. Selective sintering was carried out by NIR using an aluminum foil mask placed on the printed pattern; it was found that only the unmasked area was sintered.

Similar selective sintering may be obtained by using laser scanning of a specific area of a printed pattern.

### Example 3: Printing conductive patterns on various substrates

The paste as describes in formulation #16 in example 1 was printed by screen printing on various substrates to form conductive lines:
(a) Paper
(b) Silicon wafer
(c) Silicon wafer coated by ITO
(d) Glass coated by ITO
(e) Kapton (polyimide film)

After printing, the patterns were dried for 30-120 sec on a hot plate (60-120 °C). Then, the printed patterns were sintered by inserting the dried patter between two hot plates (300 °C) for 5 sec. High conductivities of up to 30% bulk Cu were obtained.

### Example 4: Forming various working devices

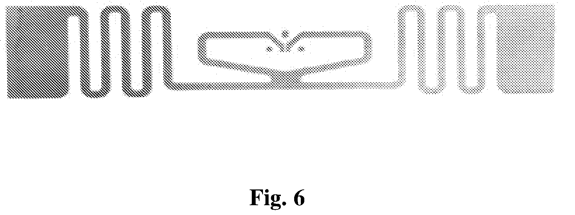

4.1 RFID antenna: An E52 RFID antenna was printed on paper as described in example 3. Then, a chip was attached to the antenna and the performance of the antenna was characterized. It was found that the antenna performance is comparable to those of etched antennas with about -6.5 dBm. **Fig. 6** shows a photo of such an E52 antenna printed on paper.
4.2 NFC antenna: A standard NFC antenna was printed on paper as described in example 3. Then, an NFC chip was attached to the antenna. The NFC performance was evaluated by placing the device near a smartphone. The smartphone responded to the NFC and enabled the storage of data for example a link to a website.
4.3 Solar cells front electrode: Conductive lines were printed on top of a heterojunction solar cell (Si wafer coated by ITO) as described in example 3.
4.4 HDTV antennas: HDTV antennas were printed according to a specific design on paper as described in example 3.

### Example 5: Phosphor detection

In order to detect phosphor in the sintered pattern, EDX analysis was carried out. The analysis was carried out for a pattern printed by formulation #21 (Table 1) and sintered at 150 °C for 30 sec.

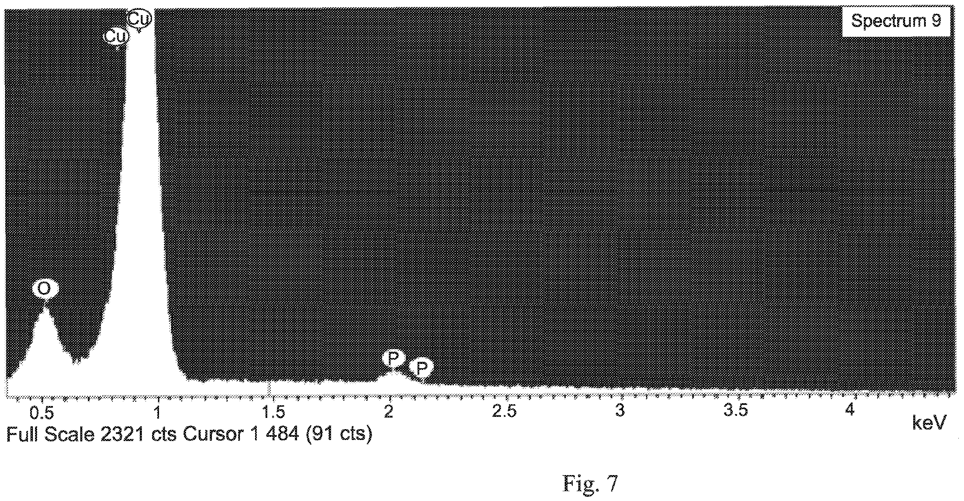

The EDX results presented in **Fig. 7** clearly indicate the presence of Copper (with a very large peak at 0.93 keV) and Phosphor (with a peak at 2.013 keV).

## Claims

1. An ink formulation comprising copper nanoparticles, at least one copper-oxidizing agent, and CuH.

2. The ink formulation of claim 1, comprising at least 0.0001 wt% of CuH.

3. The ink formulation of claim 1, wherein said copper-oxidizing agent is selected from organic acids, inorganic acids and anhydrides, alcohols, aldehydes, and hydroxyamines.

4. The ink formulation of claim 3, wherein the inorganic acid or anhydride is a phosphorous-containing compound.

5. The ink formulation of claim 4, wherein the phosphorous-containing compound is selected from hypophosphorous acid, phosphorous acid, phosphoric acid, pyrophosphoric acid (H₄P₂O₇), tripolyphosphoric acid (H₅P₃O₁₀), tetrapolyphosphoric acid (H₆P₄O₁₃), trimetaphosphoric acid (H₃P₃O₉), phosphoric anhydride (P₄O₁₀), polyphosphoric acid, hypophosphoric acid (H₄P₂O₆), pyrophosphorous acid (H₄P₂O₅), and metaphosphorous acid (HPO₂), and mixtures thereof.

6. The ink formulation of claim 5, wherein the phosphorous-containing compound is hypophosphorous acid (HPA).

7. The ink formulation of any one of claims 1 to 6, wherein the formulation comprises between 10 and 90 wt% of copper nanoparticles; and/or wherein the formulation comprises between 0.001 and 20 wt% of said copper-oxidizing agent; and/or wherein the ratio between the copper-oxidizing agent and the copper nanoparticles is between 0.001 and 0.2 (wt/wt).

8. The ink formulation of claim 1 being in the form of a dispersion or a paste.

9. A kit for preparing an ink formulation of claim 1, comprising:
a first container comprising a dispersion or a paste of copper nanoparticles in a liquid carrier; and a second container comprising a solution of at least one copper-oxidizing agent.

10. A printed pattern comprising the ink formulation of claim 1.

11. A sintered printed pattern comprising copper and up to 0.1 mol% phosphorous.

12. A process for obtaining a pattern onto a substrate, the process comprising:
(a) applying a dispersion or a paste that comprises copper nanoparticles in a liquid carrier onto at least a surface region of the substrate;
(b) applying at least one copper-oxidizing agent to said substrate;
(c) permitting at least a portion of the copper nanoparticles to react with said copper-oxidizing agent for transforming Cu⁰ into CuH,
thereby obtaining a pattern of an ink formulation onto the substrate.

13. A process for obtaining a conductive copper pattern onto a substrate, the process comprising:
printing an ink formulation of claim 1 onto at least a surface region of said substrate to obtain a pattern-bearing substrate;
exposing said pattern-bearing substrate to conditions permitting decomposition of CuH and sintering of copper, said exposing being for a period of time of between about 0.01 and 600 seconds, to thereby obtain a conductive copper pattern.

14. A process for obtaining a conductive copper pattern onto a substrate, the process comprising:
(i) printing a dispersion or a paste that comprises copper nanoparticles in a liquid carrier onto at least a surface region of the substrate;
(ii) applying at least one copper-oxidizing agent to said substrate;
(iii) permitting at least a portion of the copper nanoparticles to react with said copper-oxidizing agent for transforming Cu⁰ into CuH, to thereby obtain a pattern-bearing substrate, the pattern comprising the ink formulation of claim 1;
(iv) exposing said pattern-bearing substrate to conditions permitting decomposition of CuH and sintering of copper, said exposing being for a period of time of between about 0.001 and 600 seconds, to thereby obtain a conductive copper pattern.

15. A conductive copper pattern having % bulk conductivity of at least 5%, the pattern obtained by the process of any one of claims 13 to 14.

## Patentansprüche

1. Tintenformulierung, die Kupfer-Nanopartikel, mindestens ein Kupferoxidationsmittel und CuH aufweist.

2. Tintenformulierung nach Anspruch 1, die mindestens 0,0001 Gew.-% CuH aufweist.

3. Tintenformulierung nach Anspruch 1, wobei das Kupferoxidationsmittel aus organischen Säuren, anorganischen Säuren und Anhydriden, Alkoholen, Aldehyden und Hydroxyaminen ausgewählt ist.

4. Tintenformulierung nach Anspruch 3, wobei die anorganische Säure oder das Anhydrid eine phosphorhaltige Verbindung ist.

5. Tintenformulierung nach Anspruch 4, wobei die phosphorhaltige Verbindung aus hypophosphoriger Säure, phosphoriger Säure, Phosphorsäure, Pyrophosphorsäure (H₄P₂O₇), Tripolyphosphorsäure (H₅P₃O₁₀), Tetrapolyphosphorsäure (H₆P₄O₁₃), Trimetaphosphorsäure (H₃P₃O₉), Phosphoranhydrid (P₄O₁₀), Polyphosphorsäure, Hypophosphorsäure (H₄P₂O₆), pyrophosphoriger Säure (H₄P₂O₅) und metaphosphoriger Säure (HPO₂) und Mischungen daraus ausgewählt ist.

6. Tintenformulierung nach Anspruch 5, wobei die phosphorhaltige Verbindung Hypophosphorsäure (HPA) ist.

7. Tintenformulierung nach einem der Ansprüche 1 bis 6, wobei die Formulierung zwischen 10 und 90 Gew.-% Kupfer-Nanopartikel aufweist; und/oder wobei die Formulierung zwischen 0,001 und 20 Gew.-% des Kupferoxidationsmittels aufweist; und/oder wobei das Verhältnis zwischen dem Kupferoxidationsmittel und den Kupfer-Nanopartikeln zwischen 0,001 und 0,2 (Gew./Gew.) ist.

8. Tintenformulierung nach Anspruch 1, die die Form einer Dispersion oder einer Paste hat.

9. Ausrüstungssatz für die Herstellung einer Tintenformulierung nach Anspruch 1, der aufweist:
einen ersten Behälter, der eine Dispersion oder eine Paste aus Kupfer-Nanopartikeln in einem flüssigen Träger aufweist; und einen zweiten Behälter, der eine Lösung aus mindestens einem Kupferoxidationsmittel aufweist.

10. Gedrucktes Muster, das die Tintenformulierung nach Anspruch 1 aufweist.

11. Gesintertes gedrucktes Muster, das Kupfer und bis zu 0,1 Mol-% Phosphor aufweist.

12. Verfahren zum Gewinnen eines Musters auf einem Substrat, wobei das Verfahren aufweist:
(a) Auftragen einer Dispersion oder einer Paste, die Kupfer-Nanopartikel in einem flüssigen Träger aufweist, auf mindestens eine Oberflächenregion des Substrats;
(b) Auftragen mindestens eines Kupferoxidationsmittels auf das Substrat;
(c) Reagierenlassen mindestens eines Teils der Kupfer-Nanopartikel mit dem Kupferoxidationsmittel zur Umwandlung von Cu⁰ in CuH,
wodurch ein Muster einer Tintenformulierung auf dem Substrat gewonnen wird.

13. Verfahren zum Gewinnen eines leitfähigen Kupfermusters auf einem Substrat, wobei das Verfahren aufweist:
Drucken einer Tintenformulierung nach Anspruch 1 auf mindestens eine Oberflächenregion des Substrats, um ein mustertragendes Substrat zu gewinnen;
Aussetzen des mustertragenden Substrats gegenüber Bedingungen, die eine Zersetzung von CuH und ein Sintern von Kupfer erlauben, wobei das Aussetzen für einen Zeitraum von zwischen circa 0,01 und 600 Sekunden erfolgt, um dadurch ein leitfähiges Kupfermuster zu gewinnen.

14. Verfahren zum Gewinnen eines leitfähigen Kupfermusters auf einem Substrat, wobei das Verfahren aufweist:
(i) Drucken einer Dispersion oder einer Paste, die Kupfer-Nanopartikel in einem flüssigen Träger aufweist, auf mindestens eine Oberflächenregion des Substrats;
(ii) Auftragen mindestens eines Kupferoxidationsmittels auf das Substrat;
(iii) Reagierenlassen mindestens eines Teils der Kupfer-Nanopartikel mit dem Kupferoxidationsmittel zur Umwandlung von Cu⁰ in CuH, um dadurch ein mustertragendes Substrat zu gewinnen, wobei das Muster die Tintenformulierung nach Anspruch 1 aufweist;
(iv) Aussetzen des mustertragenden Substrats gegenüber Bedingungen, die eine Zersetzung von CuH und ein Sintern von Kupfer erlauben, wobei das Aussetzen für einen Zeitraum von zwischen circa 0,001 und 600 Sekunden erfolgt, um dadurch ein leitfähiges Kupfermusterzu gewinnen.

15. Leitfähiges Kupfermuster mit einer %-Massenleitfähigkeit von mindestens 5%, wobei das Muster durch das Verfahren nach einem der Ansprüche 13 bis 14 gewonnen ist.

## Revendications

1. Formulation d'encre comprenant des nanoparticules de cuivre, au moins un agent oxydant du cuivre et du CuH.

2. Formulation d'encre selon la revendication 1, comprenant au moins 0,0001 % en poids de CuH.

3. Formulation d'encre selon la revendication 1, dans laquelle ledit agent oxydant du cuivre est sélectionné parmi les acides organiques, les acides inorganiques et les anhydrides, les alcools, les aldéhydes et les hydroxyamines.

4. Formulation d'encre selon la revendication 3, dans laquelle l'acide inorganique ou l'anhydride est un composé contenant du phosphore.

5. Formulation d'encre selon la revendication 4, dans laquelle le composé contenant du phosphore est sélectionné parmi l'acide hypophosphoreux, l'acide phosphoreux, l'acide phosphorique, l'acide pyrophosphorique (H₄P₂O₇), l'acide tripolyphosphorique (H₅P₃O₁₀), l'acide tétrapolyphosphorique (H₆P₄O₁₃), l'acide trimétaphosphorique (H₃P₃O₉), l'anhydride phosphorique (P₄O₁₀), l'acide polyphosphorique, l'acide hypophosphorique (H₄P₂O₆), l'acide pyrophosphoreux (H₄P₂O₅), et l'acide métaphosphoreux (HPO₂), et des mélanges de ceux-ci.

6. Formulation d'encre selon la revendication 5, dans laquelle le composé contenant du phosphore est de l'acide hypophosphoreux (HPA).

7. Formulation d'encre selon une quelconque des revendications 1 à 6, dans laquelle la formulation comprend entre 10 et 90 % en poids de nanoparticules de cuivre ; et/ou dans laquelle
la formulation comprend entre 0,001 et 20 % en poids dudit agent oxydant du cuivre ; et/ou dans laquelle le rapport entre l'agent oxydant du cuivre et les nanoparticules de cuivre est entre 0,001 et 0,2 (wt/wt).

8. Formulation d'encre selon la revendication 1 étant sous la forme d'une dispersion ou d'une pâte.

9. Jeu de préparation d'une formulation d'encre selon la revendication 1, comprenant :
un premier récipient comprenant une dispersion ou une pâte de nanoparticules de cuivre dans un porteur liquide ; et un second récipient comprenant une solution d'au moins un agent oxydant du cuivre.

10. Modèle imprimé comprenant la formulation d'encre selon la revendication 1.

11. Modèle imprimé fritté comprenant du cuivre et jusqu'à 0,1 % molaires de phosphore.

12. Procédé d'obtention d'un modèle sur un substrat, le procédé comprenant :
(a) l'application d'une dispersion ou d'une pâte qui comprend des nanoparticules de cuivre dans un porteur liquide sur au moins une région de surface du substrat ;
(b) l'application d'au moins un agent oxydant du cuivre sur ledit substrat ;
(c) l'autorisation d'au moins une partie des nanoparticules de cuivre à réagir avec ledit agent oxydant du cuivre en vue de la transformation du Cu⁰ en CuH,
et ainsi de l'obtention d'un modèle d'une formulation d'encre sur le substrat.

13. Procédé d'obtention d'un modèle sur un substrat, le procédé comprenant :
l'impression d'une formulation d'encre selon la revendication 1 sur au moins une région de surface dudit substrat afin d'obtenir un substrat porteur du modèle ;
l'exposition dudit substrat porteur du modèle aux conditions permettant la décomposition du CuH et le frittage du cuivre, ladite exposition étant pendant une période de temps entre environ 0,01 et 600 secondes, afin d'obtenir ainsi un modèle de cuivre conducteur.

14. Procédé d'obtention d'un modèle sur un substrat, le procédé comprenant :
(i) l'impression d'une dispersion ou d'une pâte qui comprend des nanoparticules de cuivre dans un porteur liquide sur au moins une région de surface du substrat ;
(ii) l'application d'au moins un agent oxydant du cuivre sur ledit substrat ;
(iii) l'autorisation d'au moins une partie des nanoparticules de cuivre à réagir avec ledit agent oxydant du cuivre en vue de la transformation du Cu⁰ en CuH,
pour obtenir ainsi un substrat porteur de modèle, le modèle comprenant la formulation d'encre selon la revendication 1 ;
(iv) l'exposition dudit substrat porteur du modèle aux conditions permettant la décomposition du CuH et le frittage du cuivre, ladite exposition étant pendant une période de temps entre environ 0,001 et 600 secondes, afin d'obtenir ainsi un modèle de cuivre conducteur.

15. Modèle de cuivre conducteur possédant un pourcentage de conductivité volumique d'au moins 5 %, le modèle étant obtenu par le procédé selon une quelconque des revendications 13 à 14.
